# EUROPEAN PATENT SPECIFICATION

(11) **EP 3 761 326 B1**
(45) Date of publication and mention of the grant of the patent: **29.04.2026**
(21) Application number: 19776727.0
(22) Date of filing: 15.03.2019
(51) Int. Cl.: H01F 41/02, C23C 14/56, C23C 14/06, C23C 16/54, C23C 16/34

(54) **EQUIPMENT FOR MANUFACTURING GRAIN-ORIENTED ELECTROMAGNETIC STEEL SHEET**
GERÄT ZUR HERSTELLUNG EINES KORNORIENTIERTEN ELEKTROMAGNETISCHEN STAHLBLECHS
ÉQUIPEMENT DE FABRICATION DE FEUILLE D'ACIER ÉLECTROMAGNÉTIQUE À GRAINS ORIENTÉS

(30) Priority: 30.03.2018 JP 2018066622
(43) Date of publication of application: 06.01.2021
(73) Proprietor: JFE Steel Corporation, Tokyo 100-0011 (JP)
(72) Inventor: UMADA, Takumi, Tokyo 100-0011 (JP); TAKAJO, Shigehiro, Tokyo 100-0011 (JP); TERASHIMA, Takashi, Tokyo 100-0011 (JP)
(74) Representative: Haseltine Lake Kempner LLP
(86) International application number: PCT/JP2019/010833
(87) International publication number: WO 2019/188410

(56) References cited:
- EP-A1- 2 354 272
- JP-A- 2003 253 442
- JP-A- 2003 253 442
- JP-A- 2010 280 943
- JP-A- 2015 145 528
- JP-A- H01 176 034
- JP-A- S6 240 367
- JP-A- S6 240 367
- JP-A- S6 240 368
- JP-A- S6 269 505
- JP-A- S6 269 505
- JP-A- S6 465 259
- JP-A- S6 465 259
- US-A- 3 123 493
- US-A- 3 531 319
- US-A1- 2010 310 767

## Description

The present invention relates to a facility for producing grain oriented electrical steel sheets.

### BACKGROUND ART

Grain oriented electrical steel sheets are soft magnetic materials used as materials for iron cores of transformers, generators and the like. Grain oriented electrical steel sheets are characterized in having a crystal structure in which the <001> orientation that is an easy magnetization axis of iron is highly-precisely aligned in the rolling direction of the steel sheet. The texture as above is formed through final annealing of a manufacturing process of a grain oriented electrical steel sheet, which final annealing allows crystal grains with the {110}<001> orientation referred to as the so-called Goss orientation to preferentially grow to an enormous size. Grain oriented electrical steel sheets as products are required to have such magnetic properties as high magnetic flux density and low iron loss.

The magnetic properties of a grain oriented electrical steel sheet are improved by applying a tensile stress (tension) to a steel sheet surface. As one conventional technique of applying a tensile stress to a steel sheet, a technique in which a forsterite coating of about 2 µm thickness is formed on a steel sheet surface and another coating of about 2 µm thickness primarily composed of silicon phosphate is formed on the forsterite coating is typically used.

To be more specific, the silicon phosphate coating having a lower thermal expansion coefficient than that of the steel sheet is formed at high temperature and cooled to room temperature, whereby a tensile stress is applied to the steel sheet using a difference in thermal expansion coefficient between the steel sheet and the silicon phosphate coating.

This silicon phosphate coating also acts as an insulating coating that is indispensable for a grain oriented electrical steel sheet. Owing to the insulation, a local eddy current is prevented from being generated in the steel sheet.

A surface of the grain oriented electrical steel sheet having undergone final annealing is smoothed by chemical polishing or electrolytic polishing, and then a tensile stress is applied by means of the coating above the steel sheet, whereby iron loss can remarkably be decreased.

Meanwhile, the forsterite coating between the steel sheet and the silicon phosphate coating adheres to the steel sheet owing to the anchoring effect. Therefore, the smoothness of the steel sheet surface inevitably deteriorates. Further, the adhesion between silicon phosphate and metal is so low that a silicon phosphate coating cannot be formed directly on a mirror-finished surface of a steel sheet. Thus, in the coating structure of a conventional grain oriented electrical steel sheet (steel sheet/ forsterite coating/ silicon phosphate coating), a surface of a steel sheet cannot be smoothed.

In Patent Literature 1, in order to maintain the smoothness of a steel sheet surface and also apply a large tensile stress to the steel sheet, a ceramic coating composed of TiN for instance is formed on the steel sheet by a CVD method or a PVD method. This coating formation is carried out at high temperatures not lower than 400°C under a reduced pressure condition.

Patent Literature 2 discloses a production facility suitable for such coating formation.

Patent Literature 3 discloses carrying out continuous composite coating in a short time without injuring a band plate, by providing slits through which a band plate is passed to respective bulkheads among connected plural coating chambers and holding the band plate by means of guide rollers on respective upper edges of the slits.

Patent Literature 4 discloses improving the magnetic characteristics of a steel plate by making the surface temperature of a guide member used for the guidance of a silicon steel plate under contact after a deposition layer is formed at + or -100 deg.C or lower temperature.

Patent Literature 5 discloses a continuous vacuum treatment apparatus in which inflow of air is suppressed, a work is carried into a vacuum chamber without any flaps or damages, and subjected to a vacuum treatment such as vacuum vapor deposition.

Patent Literature 6 discloses a vapor deposition apparatus including: a vacuum tank; an exhaust section that performs vacuum exhaust in the vacuum tank; a vapor deposition source disposed in the vacuum tank to vaporize a deposition material; and a traveling path for allowing an elongated substrate on which the deposition material is deposited to travel along a concave path with respect to the vapor deposition source at least in a region opposing the vapor deposition source.

Patent Literature 7 seeks to effectively deposit and form a tensile film on the surface of a grain oriented silicon steel sheet and decrease the iron loss thereof by continuously executing the polishing treatment of said steel sheet to a specular surface and ion plating treatment thereof with a single line.

Further, US 3 123 493 A discloses a faciltiy for producing grain oriented electrical steel sheets comprising an entry / exit decompression facility disposed on an entry / exit side of the coating formation chamber and having multistage entry / exit decompression chambers. EP 2 354 272 A1 discloses a roll-to-roll apparatus for coating simultaneously internal and external surfaces of a pipe. JP 2015 145528 A discloses a vertical nitriding-treatment installation structure of grain oriented electromagnetic steel sheet. US 3 531 319 A discloses an apparatus for the coating in vacuo of a ribbon of material such as glass, paper or plastic, moving continuously through the coating chamber.

### CITATION LIST

### PATENT LITERATURES

Patent Literature 1: JP 01-176034 A
Patent Literature 2: JP 62-040368 A
Patent Literature 3: JP S64 65259 A
Patent Literature 4: JP S62 69505 A
Patent Literature 5: JP 2003 253442 A
Patent Literature 6: US 2010/310767 A1
Patent Literature 7: JP S62 40367 A

### SUMMARY OF INVENTION

### TECHNICAL PROBLEMS

Final annealing carried out on grain oriented electrical steel sheets (steel sheets) involves long-time heat treatment at a high temperature, and therefore, is usually performed as "batch annealing" in which a steel sheet is annealed on a coil-by-coil basis.

In batch annealing, typically, a steel sheet coil is mounted on a coil mounting stand with a winding shaft extending in the vertical direction, a cover is put thereon, and the steel sheet coil in the cover is heated from the outside for annealing.

With this configuration, a lower portion (on the coil mounting stand side) of the steel sheet coil is sometimes crushed due to its own weight during batch annealing. Consequently, a grain oriented electrical steel sheet having undergone batch annealing (final annealing) is not completely flat in the sheet thickness direction but is deformed, for instance, undulated on one side in some cases.

When a grain oriented electrical steel sheet thus deformed through final annealing is set in a production facility of Patent Literature 2 to form a coating, problems may occur.

The production facility of Patent Literature 2 includes a coating formation chamber (high vacuum treatment tank) and multistage decompression chambers (preliminary exhaust tank rows) situated separately on the entry and exit sides of the coating formation chamber. The multistage decompression chambers are separated by partition plates in which sheet passing holes are formed, and these sheet passing holes are provided with pinch rolls (see FIG. 1 of Patent Literature 2).

Thus, the grain oriented electrical steel sheet having undergone final annealing is set in the production facility of Patent Literature 2 and therein pinched by the pinch rolls disposed in the decompression chambers on the entry and exit sides of the coating formation chamber, whereupon a deformed portion is pressurized and crushed, and this may cause breakage such as cracking.

The present invention has been made in view of the above and aims at providing a facility for producing grain oriented electrical steel sheets that reduces breakage of grain oriented electrical steel sheets having undergone final annealing.

### SOLUTION TO PROBLEMS

The present inventors have made an intensive study and as a result found that when the structure described below is employed, the foregoing object is achieved. The invention has been thus completed.

Specifically, the present invention provides the following [1] to [7].
[1] A facility for producing grain oriented electrical steel sheets, comprising:
   a conveyance mechanism configured to convey a grain oriented electrical steel sheet having undergone final annealing;
   a coating formation facility having a coating formation chamber through which the grain oriented electrical steel sheet conveyed is passed, the coating formation facility being configured to carry out coating formation on a surface of the grain oriented electrical steel sheet being passed through a coating formation area in the coating formation chamber under a reduced pressure condition;
   an entry decompression facility disposed on an entry side of the coating formation chamber and having multistage entry decompression chambers through which the grain oriented electrical steel sheet having not yet undergone the coating formation is passed, internal pressure in the multistage entry decompression chambers approaching internal pressure in the coating formation chamber toward the coating formation chamber; and
   an exit decompression facility disposed on an exit side of the coating formation chamber and having multistage exit decompression chambers through which the grain oriented electrical steel sheet having undergone the coating formation is passed, internal pressure in the multistage exit decompression chambers approaching atmospheric pressure with distance away from the coating formation chamber,
   wherein the multistage entry decompression chambers and the multistage exit decompression chambers include:
      a partition plate defining each decompression chamber and provided with a sheet passing hole shaped to allow the grain oriented electrical steel sheet to freely pass therethrough; and
      seal pads disposed in place of pinch rolls on upper and lower sides of the sheet passing hole in the partition plate,
      wherein a gap between the seal pads is 1.0 to 2.0 mm, and
      wherein the seal pads are made of resin.
[2] The facility for producing grain oriented electrical steel sheets according to [1] above,
   wherein the coating formation facility carries out the coating formation by a chemical vapor deposition method or a physical vapor deposition method.
[3] The facility for producing grain oriented electrical steel sheets according to [1] or [2] above, further comprising:
   cooling rolls which are disposed on a downstream side of the coating formation area in a conveyance direction in the coating formation chamber and through which the grain oriented electrical steel sheet having undergone the coating formation is passed.
[4] The facility for producing grain oriented electrical steel sheets according to [3] above,
   wherein the cooling rolls are bridle rolls.
[5] The facility for producing grain oriented electrical steel sheets according to any one of [1] to [4] above, further comprising:
   a polishing facility disposed on an upstream side of the coating formation chamber in a conveyance direction and configured to polish the surface of the grain oriented electrical steel sheet conveyed.
[6] The facility for producing grain oriented electrical steel sheets according to any one of [1] to [5] above, further comprising:
   a pretreatment facility having a pretreatment chamber between the multistage entry decompression chambers and the coating formation chamber, the pretreatment facility being configured to carry out pretreatment in which impurities are removed from the surface of the grain oriented electrical steel sheet having not yet undergone the coating formation and introduced into the pretreatment chamber, wherein the pretreatment is ion sputtering.
[7] The facility for producing grain oriented electrical steel sheets according to [6] above,
   wherein a partition wall is provided to separate the pretreatment chamber and the coating formation chamber,
   wherein the partition wall is provided with a partition-wall sheet passing hole shaped to allow the grain oriented electrical steel sheet to freely pass therethrough, and
   wherein the seal pads are disposed on upper and lower sides of the partition-wall sheet passing hole in the partition wall.

### ADVANTAGEOUS EFFECTS OF INVENTION

The present invention makes it possible to provide a facility for producing grain oriented electrical steel sheets that reduces breakage of grain oriented electrical steel sheets having undergone final annealing.

### BRIEF DESCRIPTION OF DRAWINGS

[FIG. 1] FIG. 1 is a schematic view schematically showing a production facility.
[FIG. 2] FIG. 2 is an enlarged schematic view showing a part of the production facility.
[FIG. 3] FIG. 3 is an enlarged schematic view showing another part of the production facility.
[FIG. 4] FIG. 4 is a schematic view showing a modification of cooling rolls.

### DESCRIPTION OF EMBODIMENTS

Described below is a preferred embodiment of a facility for producing grain oriented electrical steel sheets (hereinafter also simply called "production facility") according to the present invention. However, the present invention should not be construed as being limited to the following embodiment.

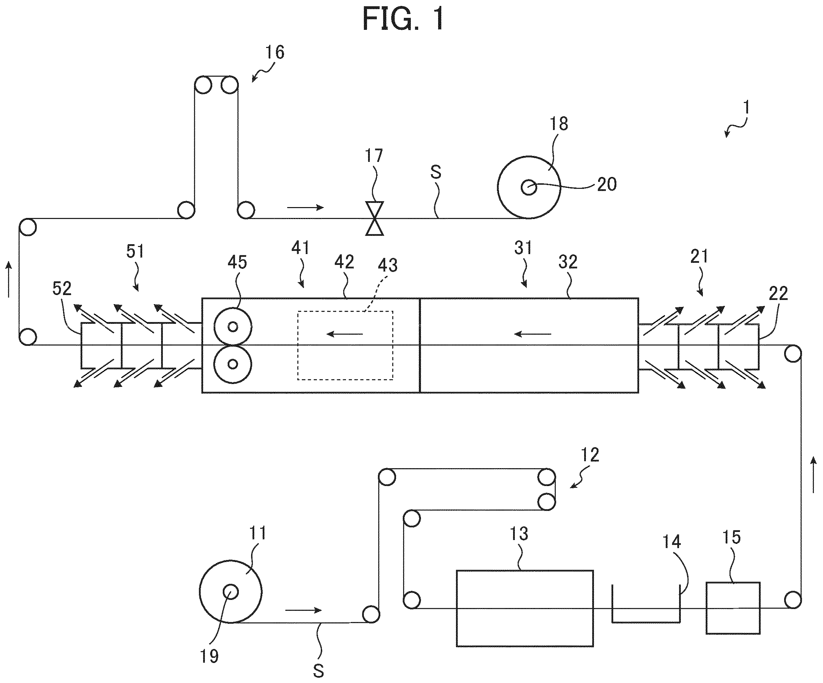

FIG. 1 is a schematic view schematically showing a production facility 1. The production facility 1 shown in FIG. 1 includes a payoff reel 19. A coil 11 before a sheet passing process (hereinafter also simply called "coil 11") formed from a grain oriented electrical steel sheet S having undergone final annealing (hereinafter also simply called "steel sheet S") is hung on the payoff reel 19. The steel sheet S pulled out from the payoff reel 19 is passed through various sections of the production facility 1 and then again wound by a winding reel 20 to form a coil 18 after a sheet passing process. The steel sheet S is conveyed in this manner. Thus, the payoff reel 19, the winding reel 20 and other components constitute a conveyance mechanism conveying the steel sheet S.

Typically, a grain oriented electrical steel sheet having undergone final annealing has a forsterite coating.

In the following, the grain oriented electrical steel sheet S having undergone final annealing that is wound as the coil 11 is assumed to be one having a forsterite coating, but may not have an oxide coating such as a forsterite coating. In the latter case, a polishing facility 13 to be described later can be omitted, so that the cost can be reduced. In the former case, it is also preferable that an oxide coating such as a forsterite coating be ultra-thin for the sake of reducing the amount of polishing in the polishing facility 13 and reducing the cost.

The production facility 1 include, in order along the direction in which the steel sheet S is conveyed, an entry looper 12, the polishing facility 13, a washing facility 14, a drying facility 15, an entry decompression facility 21, a pretreatment facility 31, a coating formation facility 41, an exit decompression facility 51, an exit looper 16, and a shear 17.

The entry decompression facility 21 has multistage entry decompression chambers 22. The pretreatment facility 31 has a pretreatment chamber 32. The coating formation facility 41 has a coating formation chamber 42. The exit decompression facility 51 has multistage exit decompression chambers 52.

The steel sheet S is conveyed in an air atmosphere except for the entry decompression chambers 22, the pretreatment chamber 32, the coating formation chamber 42 and the exit decompression chambers 52.

The steel sheet S having a forsterite coating as pulled out from the coil 11 is passed through the entry looper 12 and introduced into the polishing facility 13. The polishing facility 13 is disposed on the upstream side of the coating formation chamber 42 in the conveyance direction.

The polishing facility 13 polishes a surface of the introduced steel sheet S. Polishing in the polishing facility 13 is not particularly limited and may be any of mechanical polishing, electrolytic polishing and chemical polishing, or a combination of two or more of these; however, it is preferable to first carry out mechanical polishing such as grinding. By doing so, it is possible to easily remove an oxide coating which is polished at a lower polishing rate than a steel substrate of the steel sheet S in electrolytic polishing or chemical polishing, so that the final surface roughness can be reduced. The surface roughness of the steel sheet S after polishing is preferably an arithmetic mean roughness Ra of not more than 0.4 µm.

Polishing swarf is generated from the steel sheet S in polishing in the polishing facility 13. The washing facility 14 and the drying facility 15 remove the polishing swarf generated from the steel sheet S by washing the steel sheet S with water, followed by drying. Conventionally known techniques are used for washing with water and drying.

The steel sheet S from which polishing swarf has been removed is introduced into the entry decompression chambers 22 of the entry decompression facility 21. The internal pressure in the multistage entry decompression chambers 22 is reduced stepwise toward the pretreatment chamber 32 and the coating formation chamber 42. Thus, the pressure applied to the steel sheet S approaches the internal pressure in the pretreatment chamber 32 and the coating formation chamber 42 from the atmospheric pressure.

The steel sheet S having been passed through the entry decompression chambers 22 is introduced into the pretreatment chamber 32 of the pretreatment facility 31 and subjected to pretreatment under a reduced pressure condition to remove impurities adhering to the surface.

The steel sheet S having undergone the pretreatment is introduced into the coating formation chamber 42 of the coating formation facility 41. A coating is formed on the surface of the steel sheet S being passed through the coating formation area 43 in the coating formation chamber 42 under a reduced pressure condition.

The steel sheet S on which the coating has been formed is introduced into the exit decompression chambers 52 of the exit decompression facility 51. The internal pressure in the multistage exit decompression chambers 52 is increased stepwise with distance away from the coating formation chamber 42. Thus, the pressure applied to the steel sheet S returns from the internal pressure in the pretreatment chamber 32 and the coating formation chamber 42 to the atmospheric pressure.

The steel sheet S having left the exit decompression facility 51 is then passed through the exit looper 16 and introduced into the shear 17. The shear 17 cuts and shapes edges of the steel sheet S. The shaped steel sheet S is wound around the winding reel 20 to form the coil 18 after a sheet passing process.

Next, the entry decompression facility 21, the pretreatment facility 31, the coating formation facility 41 and the exit decompression facility 51 are described in further detail.

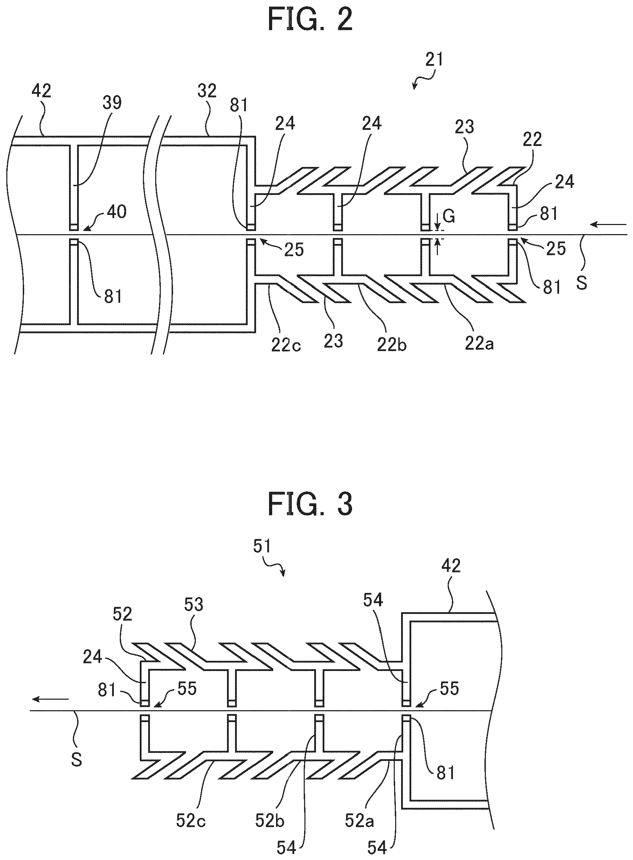

FIG. 2 is an enlarged schematic view showing a part of the production facility 1. First, the entry decompression facility 21 is described in further detail with reference to FIG. 2.

The multistage entry decompression chambers 22 of the entry decompression facility 21 are disposed on the entry side of the coating formation chamber 42 via the pretreatment chamber 32. For convenience, the respective entry decompression chambers 22 are called an entry decompression chamber 22a, an entry decompression chamber 22b and an entry decompression chamber 22c in order along the direction in which the steel sheet S is conveyed.

The coating formation in the coating formation chamber 42 (and the pretreatment in the pretreatment chamber 32) is carried out under a reduced pressure condition. For instance, if the steel sheet S under an atmospheric pressure condition is directly introduced into the coating formation chamber 42 or the pretreatment chamber 32, the steel sheet S may be greatly distorted in a wavy fashion due to the pressure difference.

Therefore, in the entry decompression facility 21, the internal pressure is reduced stepwise in the multistage entry decompression chambers 22. This can minimize the wavy distortion of the steel sheet S caused by the pressure difference. The number of the stages of the entry decompression chambers 22 is not particularly limited as long as it is at least two, and is preferably at least three for the sake of efficiently reducing the internal pressure.

The entry decompression chambers 22 are defined by a plurality of partition plates 24. Each partition plate 24 is provided with a sheet passing hole 25 shaped to allow the steel sheet S to freely pass therethrough. The partition plates 24 include not only a partition plate separating two adjacent entry decompression chambers 22 but also a partition plate facing the external environment (i.e., the partition plate 24 defining the right side of the entry decompression chamber 22a in FIG. 2) and a partition plate in contact with the pretreatment chamber 32 (i.e., the partition plate 24 defining the left side of the entry decompression chamber 22c in FIG. 2).

The entry decompression chambers 22 are further provided with exhaust ports 23. Gas in the entry decompression chambers 22 is discharged through the exhaust ports 23, whereby the pressure is reduced in the entry decompression chambers 22. The pressure (internal pressure) in the entry decompression chambers 22 is reduced stepwise toward the coating formation chamber 42. More specifically, the internal pressure gradually approaches the internal pressure in the pretreatment chamber 32 and the coating formation chamber 42 from the pressure close to the atmospheric pressure in the order of the entry decompression chamber 22a, the entry decompression chamber 22b and the entry decompression chamber 22c.

In the entry decompression facility 21, gas is discharged through the exhaust ports 23 taking into consideration the amount of air entering from the sheet passing holes 25, the amount of gas volatilized from the surface of the steel sheet S, and other factors, thereby achieving a desired internal pressure.

As described above, pinch rolls are provided in the sheet passing holes 25 of the partition plates 24 in conventional production facilities (see FIG. 1 of Patent Literature 2). In the case where the steel sheet S has been deformed during batch annealing, upon being pinched by the pinch rolls, the deformed portion is pressurized and crushed, and this may cause breakage such as cracking.

To cope with it, in this embodiment, seal pads 81 are disposed on the upper and lower sides of the sheet passing hole 25 in the partition plate 24 in place of the pinch rolls. Since the steel sheet S is passed through a gap between the seal pads 81, even if the steel sheet S has a deformed shape, pressurization by pinching is avoided, and breakage such as cracking can be prevented.

When gas in the entry decompression chambers 22 flows through the sheet passing holes 25 of the partition plates 24, the flow velocity increases because the sectional area of the flow path decreases. Accordingly, the steel sheet S being passed through the sheet passing hole 25 may flap and hit the upper and lower sides of the sheet passing hole 25 in the partition plate 24.

In this embodiment, however, the seal pads 81 are disposed on the upper and lower sides of the sheet passing hole 25 in the partition plate 24. The material of the seal pads 81 is flexible resin. Therefore, even when the steel sheet S being passed through the sheet passing hole 25 flaps and hits the upper and lower sides of the sheet passing hole 25 in the partition plate 24, the steel sheet S is prevented from having scratches and the like owing to the presence of the seal pads 81. With the seal pads 81 made of resin, distortion that may be generated in the steel sheet S being passed between the seal pads 81 can also be reduced.

The gap (given a reference sign "G" in FIG. 2) between the seal pads 81 is 1.0 to 2.0 mm. The gap should not be more than 3.0 mm because the reduced pressure atmosphere can be easily maintained, and is 1.0 to 2.0 mm because the surface of the steel sheet S is not readily scratched while the reduced pressure atmosphere can be easily maintained.

Next, the pretreatment facility 31 and the coating formation facility 41 are described in further detail with reference to FIGS. 1 and 2.

The steel sheet S having been passed through the entry decompression chambers 22 is introduced into the pretreatment chamber 32 of the pretreatment facility 31 and subjected to the pretreatment in which impurities such as oxides adhering to the surface of the steel sheet S are removed under a reduced pressure condition.

The pretreatment prior to coating formation allows a coating (e.g., a nitride coating) formed in the coating formation facility 41 to have remarkably improved adhesion to the steel sheet S. Therefore, although not essential, it is preferable to provide the pretreatment facility 31.

A favorable method of the pretreatment is ion sputtering. In the case of ion sputtering, preferred examples of ion species of a sputtering material for use include ions of inert gases such as argon and nitrogen and ions of metals such as Ti and Cr.

The pressure in the pretreatment chamber 32 is reduced, and the internal pressure in the pretreatment chamber 32 is preferably 0.0001 to 30 Pa for the sake of increasing the mean free path of sputtering ions.

A bias voltage of -100 to -1000 V is preferably applied between the steel sheet S serving as the cathode and the sputtering material.

The steel sheet S having undergone the pretreatment is introduced into the coating formation chamber 42 of the coating formation facility 41. A coating is formed on the surface of the steel sheet S being passed through the coating formation area 43 in the coating formation chamber 42 under a reduced pressure condition.

The method of coating formation is preferably a CVD (Chemical Vapor Deposition) method or a PVD (Physical Vapor Deposition) method. Raw material gas (atmospheric gas) for coating formation, such as nitrogen gas or TiCl₄ gas for instance, is introduced into the coating formation chamber 42. The steel sheet S being passed through the coating formation area 43 is heated whereby a coating such as a nitride coating is formed on the surface of the steel sheet S.

For a means for heating the steel sheet S, since gas in the coating formation chamber 42 is discharged so that a reduced pressure condition is established, the use of a burner or such devices is naturally improper; however, any means may be suitably adopted without particular limitation as long as it is a means that does not require oxygen, such as induction heating (IH), electron beam irradiation, laser light, or infrared light.

A preferred CVD method is a thermal CVD method. The coating formation temperature is preferably 700°C to 1100°C, and the pressure (internal pressure) in the coating formation chamber 42 is preferably 30 to 1000 Pa.

A preferred PVD method is an ion plating method. The coating formation temperature is preferably 300°C to 600°C, and the pressure (internal pressure) in the coating formation chamber 42 is preferably 0.10 to 100 Pa. During the coating formation, a bias voltage of -10 to -1000 V is preferably applied between the steel sheet S serving as the cathode and a coating formation raw material. When plasma is used for ionization of the coating formation raw material, the coating formation rate can be increased.

For the coating formed on the steel sheet S, a nitride coating is preferred, a metal nitride coating is more preferred, and a metal nitride coating including at least one metal selected from the group consisting of Zn, V, Cr, Mn, Fe, Co, Ni, Cu, Ti, Y, Nb, Mo, Hf, Zr, W and Ta is even more preferred. These coatings can easily have a rock salt structure, and since this structure easily matches the body-centered cubic lattice of the steel substrate of the steel sheet S, the adhesion of the coating can be improved.

The coating formed on the steel sheet S may be a single layer coating or a multilayer coating.

In the pretreatment chamber 32 and the coating formation chamber 42, factors influencing the internal pressure are, for example, the amount of gas generated upon reaction on the surface of the steel sheet S and the amount of raw material gas introduced. Meanwhile, particularly in the coating formation chamber 42, when gas is excessively discharged, the raw material gas may not be sufficiently delivered to the steel sheet S. In view of these points, gas is discharged to achieve a desired internal pressure.

In the figures, exhaust ports, inlet ports for introducing the raw material gas, and the like of the pretreatment chamber 32 and the coating formation chamber 42 are not illustrated.

In the coating formation chamber 42, the amount of discharged gas is preferably 0.50 to 2.0 times as much as the amount of introduced raw material gas when a CVD method is adopted, and is preferably 0.50 to 1.0 times as much as the amount of introduced raw material gas when a PVD method is adopted.

As shown in FIG. 2, a partition wall 39 is provided between the pretreatment chamber 32 and the coating formation chamber 42 to separate those chambers. The partition wall 39 is provided with a partition-wall sheet passing hole 40 shaped to allow the steel sheet S to freely pass therethrough, as with the sheet passing hole 25 of the partition plate 24.

Preferably, the seal pads 81 are disposed also on the upper and lower sides of the partition-wall sheet passing hole 40 in the partition wall 39. With this configuration, even if the steel sheet S having undergone batch annealing is in a deformed shape, pressurization by pinching is avoided, and breakage such as cracking can be prevented.

While in the foregoing, resin is mentioned as an example of the material of the seal pads 81, the material is not limited thereto, and metals or other materials are also applicable.

When the pretreatment is carried out at a high temperature for a long period of time or when the thermal CVD method is used, there is a risk that the partition wall 39 and the steel sheet S are heated to high temperatures. In this case, for the material of the seal pads 81, it is preferable to select a material having heat resistance corresponding to the temperature of the steel sheet S or a material that is easily cooled. For a material having heat resistance, for instance, materials having high melting points may be employed in order to ensure heat resistance. For a material that is easily cooled, materials having high thermal conductivities may be used, specific examples of which are, for instance, lead and copper.

It is preferable that heating for forming a coating on the steel sheet S be carried out not in the pretreatment chamber 32 but after the steel sheet S is introduced into the coating formation chamber 42 for the sake of protecting the seal pads 81 disposed on the upper and lower sides of the partition-wall sheet passing hole 40 in the partition wall 39. In this embodiment, the steel sheet S is heated in the coating formation area 43 in the coating formation chamber 42.

FIG. 3 is an enlarged schematic view showing another part of the production facility 1. Next, the exit decompression facility 51 is described in further detail with reference to FIG. 3. The basic structure is the same as that of the entry decompression facility 21 described above.

The multistage exit decompression chambers 52 of the exit decompression facility 51 are disposed on the exit side of the coating formation chamber 42. For convenience, the respective exit decompression chambers 52 are called an exit decompression chamber 52a, an exit decompression chamber 52b and an exit decompression chamber 52c in order along the direction in which the steel sheet S is conveyed.

In the exit decompression facility 51, the internal pressure is reduced stepwise in the multistage entry decompression chambers 52. This can minimize the wavy distortion of the steel sheet S caused by the pressure difference. The number of the stages of the exit decompression chambers 52 is not particularly limited as long as it is at least two, and is preferably at least three for the sake of efficiently reducing the internal pressure.

The exit decompression chambers 52 are defined by a plurality of partition plates 54. Each partition plate 54 is provided with a sheet passing hole 55 shaped to allow the steel sheet S to freely pass therethrough.

The partition plates 54 include not only a partition plate separating two adjacent exit decompression chambers 52 but also a partition plate facing the external environment (i.e., the partition plate 54 defining the left side of the exit decompression chamber 52c in FIG. 3) and a partition plate in contact with the coating formation chamber 42 (i.e., the partition plate 54 defining the right side of the exit decompression chamber 52a in FIG. 3).

The seal pads 81 are disposed also on the upper and lower sides of the sheet passing hole 55 in the partition plate 54 as with the sheet passing hole 25 in the partition plate 24. With this configuration, even if the steel sheet S having undergone batch annealing is in a deformed shape, pressurization by pinching is avoided, and breakage such as cracking can be prevented.

The exit decompression chambers 52 are further provided with exhaust ports 53. Gas in the exit decompression chambers 52 is discharged through the exhaust ports 53, whereby the pressure is reduced in the exit decompression chambers 52. The pressure (internal pressure) in the exit decompression chambers 52 is increased stepwise with distance away from the coating formation chamber 42. More specifically, the internal pressure gradually approaches the atmospheric pressure from the internal pressure in the coating formation chamber 42 in the order of the exit decompression chamber 52a, the exit decompression chamber 52b and the exit decompression chamber 52c.

In the exit decompression facility 51, gas is discharged through the exhaust ports 53 taking into consideration the amount of air entering from the sheet passing holes 55, the amount of gas volatilized from the surface of the steel sheet S, and other factors, thereby achieving a desired internal pressure.

Meanwhile, the steel sheet S being passed through the coating formation area 43 of the coating formation chamber 42 is heated during coating formation. If the steel sheet S that retains the heat (e.g., 300°C or higher) is passed through the exit decompression chambers 52, the seal pads 81 disposed in the partition plates 54 may be melt by the heat and worn away. When the seal pads 81 are made of resin, since resin usually has low heat resistance, the seal pads 81 are particularly easily worn away. When the seal pads 81 are worn away, the coating formation atmosphere is thereby changed, and the steel sheet S having undergone the coating formation may have poor magnetic properties. Accordingly, worn seal pads 81 need to be replaced, and if the replacement is frequently required, the maintenance work is burdensome.

To cope with it, as shown in FIG. 1, it is preferable to dispose cooling rolls 45 on the downstream side of the coating formation area 43 in the conveyance direction in the coating formation chamber 42 in this embodiment. The steel sheet S heated in the coating formation area 43 is passed through the cooling rolls 45 and thereby cooled before entering the exit decompression chambers 52. Thus, the seal pads 81 of the exit decompression chambers 52 are prevented from being worn away due to the heat of the steel sheet S.

The cooling rolls 45 are rolls that suppress an increase in temperature of the roll surfaces using cooling water circulated in the rolls. With this, the steel sheet S heated in the coating formation area 43 can be cooled to, for instance, a temperature of lower than 200°C.

Since the cooling rolls 45 are disposed in the coating formation chamber 42, when metal is exposed on the roll surfaces, a nitride coating may be formed thereon by a CVD or PVD method.

If such a coating is formed on the surfaces of the cooling rolls 45, a distance between the rolls is changed, which may result in distortion at the edges of the steel sheet. However, rolls made of resin such as rubber cannot withstand a high temperature of 300°C or higher.

Therefore, preferably, the cooling rolls 45 are made of metal and are subjected to oxidation treatment before use. As a result, an oxide with a thickness of about 1 to about 10 µm is generated on the metal surface, and this can suppress coating formation by a CVD or PVD method.

The type of the metal is not particularly limited; since a metal having a higher thermal conductivity has a higher cooling ability, for instance, an alloy in which iron is combined with a high thermal conductivity metal such as aluminum (iron-aluminum alloy) is preferred.

The conditions of oxidation treatment vary depending on the type of metal, and when the iron-aluminum alloy is used, annealing in the atmosphere at 800°C for 30 seconds to 2 minutes is preferred.

A protective wall (not shown) may be provided between the coating formation area 43 and the cooling rolls 45 to prevent coating formation on the roll surfaces of the cooling rolls 45.

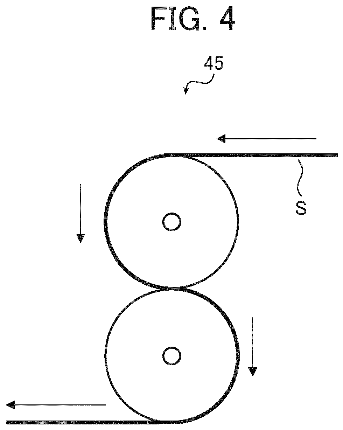

FIG. 4 is a schematic view showing a modification of the cooling rolls 45. The cooling rolls 45 are not limited to the embodiment illustrated in FIG. 1 and may be bridle rolls as shown in FIG. 4. In this case, the contact area with the steel sheet S increases, resulting in higher cooling efficiency.

While the overall view of the production facility 1 with the cooling roll 45 being bridle rolls is not shown, the arrangement in which the positions of the sheet passing holes 55 and the exit decompression chambers 52 are suitably adjusted may be employed.

### EXAMPLES

The present invention is specifically described below with reference to examples. However, the present invention is not limited thereto.

### <Test Example 1>

A coil 11 (total mass: 8 t) of a grain oriented electrical steel sheet S (sheet thickness: 0.23 mm) having undergone final annealing was set in the production facility 1 described with reference to FIGS. 1 to 3, and coating formation was carried out. The line speed was set to 30 m/min. After a forsterite coating was removed by mechanical polishing in the polishing facility 13, impurities on the surface were removed by Ar ion sputtering in the pretreatment chamber 32, and then, a TiN coating (coating thickness: 0.3 µm) was formed by a CVD method in the coating formation chamber 42. The CVD method was a thermal CVD method, the coating formation temperature was 1000°C, and the raw material was TiCl₄. The gap G between the seal pads 81 before the sheet of the coil 11 was passed therethrough was set to 1.5 mm.

As described above, in place of conventional pinch rolls, the seal pads 81 were provided in the entry decompression chambers 22 and the exit decompression chambers 52. Therefore, although the steel sheet S set in the production facility 1 was passed through the entry decompression chambers 22 and the exit decompression chambers 52 before and after being passed through the pretreatment chamber 32 and the coating formation chamber 42, breakage such as cracking due to pinching did not occur during those processes.

In Test Example 1, coating formation was carried out with rolls being provided on the downstream side of the coating formation area 43 in the conveyance direction in the coating formation chamber 42. For the rolls, three types of rolls, namely, usual rolls, cooling rolls A (the cooling rolls 45 shown in FIG. 1) and cooling rolls B (the cooling rolls 45 that are bridle rolls shown in FIG. 4) were used.

After the entire sheet of the coil 11 was completely passed through the production facility 1, the degree of wear of the seal pads 81 of the exit decompression chambers 52 and a magnetic property of the steel sheet S having undergone coating formation were obtained.

The degree of wear of the seal pads 81 was defined using the percentage of change of the gap G between the seal pads 81 as comparing the gap G before the sheet of the coil 11 was passed therethrough and the gap G after that. Specifically, when the gap G that is 2.0 mm before the sheet of the coil 11 is passed therethrough is changed to 4.0 mm after the sheet of the coil 11 is passed therethrough, the degree of wear is 100%.

For the magnetic property, the iron loss W_{17/50} (unit: W/kg) was measured (the same applies to the following).

The results are shown in Table 1 below.

### [Table 1]

**Table 1**

| Rolls | Degree of wear of seal pads | Magnetic property [W/kg] | | | Remarks |
|---|---|---|---|---|---|
| | | Outer portion of coil | Middle portion of coil | Inner portion of coil | |
| Usual rolls | 140% | 0.63 | 0.72 | 0.80 | Example |
| Cooling rolls A | 3% | 0.62 | 0.62 | 0.64 | Example |
| Cooling rolls B | 1% or lower | 0.62 | 0.61 | 0.62 | Example |

As can be seen in Table 1, when the cooling rolls A or B were used, wear of the seal pads 81 of the exit decompression chambers 52 was almost completely suppressed.

Further, in terms of the magnetic property, when use was made of the cooling rolls A or B that allowed wear of the seal pads 81 to be suppressed, a good magnetic property was observed even in the part of the steel sheet that was situated in the inner portion of the coil 11 and therefore processed later. When the cooling rolls B were used, the magnetic property was more excellent than that when the cooling rolls A were used.

### <Test Example 2>

A coil 11 (total mass: 8 t) of a grain oriented electrical steel sheet S (sheet thickness: 0.23 mm) having undergone final annealing was set in the production facility 1 described with reference to FIGS. 1 to 3, and coating formation was carried out. The line speed was set to 30 m/min. After a forsterite coating was removed by mechanical polishing in the polishing facility 13, impurities on the surface were removed by Ar ion sputtering in the pretreatment chamber 32, and then, a nitride coating shown in Table 2 below (coating thickness: 0.3 µm) was formed by a CVD method in the coating formation chamber 42. The CVD method was a thermal CVD method, and the coating formation temperature was 1000°C. The gap G between the seal pads 81 before the sheet of the coil 11 was passed therethrough was set to 1.5 mm.

As described above, in place of conventional pinch rolls, the seal pads 81 were provided in the entry decompression chambers 22 and the exit decompression chambers 52. Therefore, although the steel sheet S set in the production facility 1 was passed through the entry decompression chambers 22 and the exit decompression chambers 52 before and after being passed through the pretreatment chamber 32 and the coating formation chamber 42, breakage such as cracking due to pinching did not occur during those processes.

In Test Example 2, coating formation was carried out with rolls being provided on the downstream side of the coating formation area 43 in the conveyance direction in the coating formation chamber 42. For the rolls, two types of rolls, namely, the cooling rolls A (the cooling rolls 45 shown in FIG. 1) and the cooling rolls B (the cooling rolls 45 that are bridle rolls shown in FIG. 4) were used.

After the entire sheet of the coil 11 was completely passed through the production facility 1, the magnetic property of the steel sheet S having undergone coating formation was obtained. The results are shown in Table 2 below.

### [Table 2]

**Table 2**

| Coating | Cooling rolls | Magnetic property [W/kg] | | | Remarks |
|---|---|---|---|---|---|
| | | Outer portion of coil | Middle portion of coil | Inner portion of coil | |
| ZnN | A | 0.63 | 0.63 | 0.64 | Example |
| | B | 0.62 | 0.62 | 0.62 | Example |
| VN | A | 0.63 | 0.62 | 0.64 | Example |
| | B | 0.63 | 0.63 | 0.62 | Example |
| CrN | A | 0.63 | 0.63 | 0.65 | Example |
| | B | 0.62 | 0.63 | 0.62 | Example |
| MnN | A | 0.62 | 0.62 | 0.64 | Example |
| | B | 0.62 | 0.62 | 0.62 | Example |
| FeN | A | 0.64 | 0.63 | 0.65 | Example |
| | B | 0.64 | 0.63 | 0.63 | Example |
| CoN | A | 0.62 | 0.62 | 0.63 | Example |
| | B | 0.62 | 0.62 | 0.62 | Example |
| NiN | A | 0.62 | 0.63 | 0.64 | Example |
| | B | 0.61 | 0.62 | 0.62 | Example |
| CuN | A | 0.62 | 0.61 | 0.64 | Example |
| | B | 0.63 | 0.62 | 0.62 | Example |
| YN | A | 0.62 | 0.63 | 0.62 | Example |
| | B | 0.62 | 0.62 | 0.64 | Example |
| NbN | A | 0.62 | 0.62 | 0.64 | Example |
| | B | 0.62 | 0.61 | 0.61 | Example |
| MoN | A | 0.63 | 0.62 | 0.64 | Example |
| | B | 0.62 | 0.63 | 0.62 | Example |
| HfN | A | 0.63 | 0.63 | 0.65 | Example |
| | B | 0.61 | 0.61 | 0.61 | Example |
| ZrN | A | 0.62 | 0.62 | 0.64 | Example |
| | B | 0.62 | 0.61 | 0.62 | Example |
| WN | A | 0.63 | 0.63 | 0.65 | Example |
| | B | 0.64 | 0.63 | 0.63 | Example |
| TaN | A | 0.62 | 0.63 | 0.65 | Example |
| | B | 0.61 | 0.62 | 0.62 | Example |

As can be seen in Table 2, a good magnetic property was observed not only in the part of the steel sheet that was situated in the outer portion of the coil 11 and therefore processed earlier but also in the part of the steel sheet that was situated in the inner portion of the coil 11 and therefore processed later.

### <Test Example 3>

A coil 11 (total mass: 8 t) of a grain oriented electrical steel sheet S (sheet thickness: 0.23 mm) having undergone final annealing was set in the production facility 1 described with reference to FIGS. 1 to 3, and coating formation was carried out. The line speed was set to 30 m/min. After a forsterite coating was removed by mechanical polishing in the polishing facility 13, impurities on the surface were removed by Ar ion sputtering in the pretreatment chamber 32, and then, a nitride coating shown in Tables 3 and 4 below (coating thickness: 0.3 µm) was formed by a PVD method in the coating formation chamber 42. The PVD method was an ion plating method, and the coating formation temperature was 400°C. The gap G between the seal pads 81 before the sheet of the coil 11 was passed therethrough was set to 1.5 mm.

As described above, in place of conventional pinch rolls, the seal pads 81 were provided in the entry decompression chambers 22 and the exit decompression chambers 52. Therefore, although the steel sheet S set in the production facility 1 was passed through the entry decompression chambers 22 and the exit decompression chambers 52 before and after being passed through the pretreatment chamber 32 and the coating formation chamber 42, breakage such as cracking due to pinching did not occur during those processes.

In Test Example 3, coating formation was carried out with rolls being provided on the downstream side of the coating formation area 43 in the conveyance direction in the coating formation chamber 42. For the rolls, two types of rolls, namely, the cooling rolls A (the cooling rolls 45 shown in FIG. 1) and the cooling rolls B (the cooling rolls 45 that are bridle rolls shown in FIG. 4) were used.

After the entire sheet of the coil 11 was completely passed through the production facility 1, the magnetic property of the steel sheet S having undergone coating formation was obtained. The results thereof are shown in Tables 3 and 4 below.

### [Table 3]

**Table 3**

| Coating | Cooling rolls | Magnetic property [W/kg] | | | Remarks |
|---|---|---|---|---|---|
| | | Outer portion of coil | Middle portion of coil | Inner portion of coil | |
| ZnN | A | 0.62 | 0.62 | 0.63 | Example |
| | B | 0.62 | 0.61 | 0.62 | Example |
| VN | A | 0.64 | 0.63 | 0.65 | Example |
| | B | 0.63 | 0.62 | 0.62 | Example |
| CrN | A | 0.62 | 0.62 | 0.65 | Example |
| | B | 0.61 | 0.62 | 0.62 | Example |
| MnN | A | 0.62 | 0.62 | 0.64 | Example |
| | B | 0.62 | 0.62 | 0.62 | Example |
| FeN | A | 0.63 | 0.63 | 0.65 | Example |
| | B | 0.62 | 0.63 | 0.63 | Example |
| CoN | A | 0.62 | 0.62 | 0.64 | Example |
| | B | 0.61 | 0.62 | 0.62 | Example |
| NiN | A | 0.62 | 0.63 | 0.65 | Example |
| | B | 0.61 | 0.61 | 0.62 | Example |
| CuN | A | 0.62 | 0.61 | 0.64 | Example |
| | B | 0.63 | 0.62 | 0.62 | Example |
| TiN | A | 0.62 | 0.61 | 0.64 | Example |
| | B | 0.63 | 0.62 | 0.62 | Example |
| YN | A | 0.62 | 0.63 | 0.62 | Example |
| | B | 0.62 | 0.62 | 0.63 | Example |
| NbN | A | 0.61 | 0.62 | 0.64 | Example |
| | B | 0.62 | 0.60 | 0.61 | Example |
| MoN | A | 0.63 | 0.63 | 0.66 | Example |
| | B | 0.63 | 0.63 | 0.62 | Example |

### [Table 4]

**Table 4**

| Coating | Cooling rolls | Magnetic property [W/kg] | | | Remarks |
|---|---|---|---|---|---|
| | | Outer portion of coil | Middle portion of coil | Inner portion of coil | |
| HfN | A | 0.63 | 0.63 | 0.65 | Example |
| | B | 0.61 | 0.60 | 0.61 | Example |
| ZrN | A | 0.62 | 0.62 | 0.65 | Example |
| | B | 0.62 | 0.61 | 0.62 | Example |
| WN | A | 0.63 | 0.63 | 0.65 | Example |
| | B | 0.62 | 0.63 | 0.63 | Example |
| TaN | A | 0.62 | 0.62 | 0.65 | Example |
| | B | 0.61 | 0.62 | 0.62 | Example |
| TiCrN | A | 0.62 | 0.63 | 0.62 | Example |
| | B | 0.62 | 0.62 | 0.64 | Example |
| TiAlN | A | 0.62 | 0.61 | 0.64 | Example |
| | B | 0.63 | 0.62 | 0.62 | Example |
| TiWN | A | 0.62 | 0.63 | 0.65 | Example |
| | B | 0.61 | 0.62 | 0.62 | Example |
| TiZrN | A | 0.62 | 0.62 | 0.63 | Example |
| | B | 0.62 | 0.62 | 0.62 | Example |
| AlWN | A | 0.64 | 0.63 | 0.65 | Example |
| | B | 0.63 | 0.62 | 0.62 | Example |
| AlCrN | A | 0.62 | 0.62 | 0.62 | Example |
| | B | 0.62 | 0.61 | 0.61 | Example |
| AlZrN | A | 0.62 | 0.62 | 0.64 | Example |
| | B | 0.62 | 0.61 | 0.62 | Example |

As can be seen in Tables 3 and 4, a good magnetic property was observed not only in the part of the steel sheet that was situated in the outer portion of the coil 11 and therefore processed earlier but also in the part of the steel sheet that was situated in the inner portion of the coil 11 and therefore processed later.

### (Comparative Test of Test Example 3)

In Test Example 3, a comparative test was also conducted as below.

In the comparative test, used was a production facility (for convenience, called "production facility 1'") made by replacing the entry decompression chambers 22 in the production facility 1 described with reference to FIGS. 1 to 3 by a single-stage chamber and replacing the exit decompression chambers 52 in the same by a single-stage chamber. The production facility 1' was configured to have the same structure as that of the production facility 1 except for the number of stages of the entry decompression chambers 22 and the exit decompression chambers 52.

Coating formation was carried out using the production facility 1' in the same manner as in Examples above.

More specifically, the coil 11 (total mass: 8 t) of the grain oriented electrical steel sheet S (sheet thickness: 0.23 mm) having undergone final annealing was set in the production facility 1', and coating formation was carried out. The line speed was set to 30 m/min. After a forsterite coating was removed by mechanical polishing in the polishing facility 13, impurities on the surface were removed by Ar ion sputtering in the pretreatment chamber 32. Then, a nitride coating was formed by a PVD method (ion plating method) under conditions allowing the coating thickness to be 0.3 µm in the coating formation chamber 42 (coating formation temperature: 400°C). The gap G between the seal pads 81 before the sheet of the coil 11 was passed therethrough was set to 1.5 mm.

While coating formation was carried out using the production facility 1' under the conditions allowing the coating thickness to be 0.3 µm as described above, the obtained coating thickness was only 0.05 µm. Then, the internal pressures of the pretreatment chambers 32 and the coating formation chambers 42 in the coating formation facility 1 and the coating formation facility 1' were measured. The measurement was 3.0 Pa in the production facility 1. On the other hand, the measurement was 300 Pa in the production facility 1', and it was revealed that the decompression was insufficient.

### REFERENCE SIGNS LIST

- 1: production facility
- 11: coil
- 12: entry looper
- 13: polishing facility
- 14: washing facility
- 15: drying facility
- 16: exit looper
- 17: shear
- 18: coil after the sheet passing process
- 19: payoff reel (conveyance mechanism)
- 20: winding reel (conveyance mechanism)
- 21: entry decompression facility
- 22: entry decompression chamber
- 22a, 22b, 22c: entry decompression chamber
- 23: exhaust port
- 24: partition plate
- 25: sheet passing hole
- 31: pretreatment facility
- 32: pretreatment chamber
- 39: partition wall
- 40: partition-wall sheet passing hole
- 41: coating formation facility
- 42: coating formation chamber
- 43: coating formation area
- 45: cooling roll
- 51: exit decompression facility
- 52: exit decompression chamber
- 52a, 52b, 52c: exit decompression chamber
- 53: exhaust port
- 54: partition plate
- 55: sheet passing hole
- 81: seal pad
- G: gap
- S: grain oriented electrical steel sheet having undergone final annealing

## Claims

1. A facility (1) for producing grain oriented electrical steel sheets, comprising:
a conveyance mechanism (19, 20) configured to convey a grain oriented electrical steel sheet (S) having undergone final annealing;
a coating formation facility (41) having a coating formation chamber (42) through which the grain oriented electrical steel sheet (S) conveyed is passed, the coating formation facility (41) being configured to carry out coating formation on a surface of the grain oriented electrical steel sheet (S) being passed through a coating formation area (43) in the coating formation chamber (42) under a reduced pressure condition;
an entry decompression facility (21) disposed on an entry side of the coating formation chamber (42) and having multistage entry decompression chambers (22) through which the grain oriented electrical steel sheet (S) having not yet undergone the coating formation is passed, internal pressure in the multistage entry decompression chambers (22) approaching internal pressure in the coating formation chamber (42) toward the coating formation chamber (42); and
an exit decompression facility (51) disposed on an exit side of the coating formation chamber (42) and having multistage exit decompression chambers (52) through which the grain oriented electrical steel sheet (S) having undergone the coating formation is passed, internal pressure in the multistage exit decompression chambers (52) approaching atmospheric pressure with distance away from the coating formation chamber (42),
wherein the multistage entry decompression chambers (22) and the multistage exit decompression chambers (52) include:
a partition plate (54) defining each decompression chamber and provided with a sheet passing hole (55) shaped to allow the grain oriented electrical steel sheet (S) to freely pass therethrough; and
seal pads (81) disposed in place of pinch rolls on upper and lower sides of the sheet passing hole (55) in the partition plate (54), **characterised in that**
a gap (G) between the seal pads (81) is 1.0 to 2.0 mm, and
that the seal pads (81) are made of resin.

2. The facility (1) for producing grain oriented electrical steel sheets (S) according to claim 1,
wherein the coating formation facility (41) carries out the coating formation by a chemical vapor deposition method or a physical vapor deposition method.

3. The facility (1) for producing grain oriented electrical steel sheets (S) according to claim 1 or 2, further comprising:
cooling rolls (45) which are disposed on a downstream side of the coating formation area (43) in a conveyance direction in the coating formation chamber (42) and through which the grain oriented electrical steel sheet (S) having undergone the coating formation is passed.

4. The facility (1) for producing grain oriented electrical steel sheets (S) according to claim 3,
wherein the cooling rolls (45) are bridle rolls.

5. The facility (1) for producing grain oriented electrical steel sheets (S) according to any one of claims 1 to 4, further comprising:
a polishing facility (13) disposed on an upstream side of the coating formation chamber (42) in a conveyance direction and configured to polish the surface of the grain oriented electrical steel sheet (S) conveyed.

6. The facility (1) for producing grain oriented electrical steel sheets (S) according to any one of claims 1 to 5, further comprising:
a pretreatment facility (31) having a pretreatment chamber (32) between the multistage entry decompression chambers (22) and the coating formation chamber (42), the pretreatment facility (31) being configured to carry out pretreatment in which impurities are removed from the surface of the grain oriented electrical steel sheet (S) having not yet undergone the coating formation and introduced into the pretreatment chamber (32), wherein a method of the pretreatment is ion sputtering.

7. The facility (1) for producing grain oriented electrical steel sheets (S) according to claim 6,
wherein a partition wall (39) is provided to separate the pretreatment chamber (32) and the coating formation chamber (42),
wherein the partition wall (39) is provided with a partition-wall sheet passing hole (40) shaped to allow the grain oriented electrical steel sheet (S) to freely pass therethrough, and
wherein the seal pads (81) are disposed on upper and lower sides of the partition-wall sheet passing hole (40) in the partition wall.

## Patentansprüche

1. Anlage (1) zum Produzieren von kornorientierten Elektrostahlblechen, umfassend:
einen Fördermechanismus (19, 20), der zum Fördern eines kornorientierten Elektrostahlblechs (S), nachdem es einem abschließenden Glühen unterworfen wurde, ausgelegt ist;
eine Beschichtungsbildungsanlage (41) mit einer Beschichtungsbildungskammer (42), durch die das geförderte kornorientierte Elektrostahlblech (S) geführt wird, wobei die Beschichtungsbildungsanlage (41) zum Durchführen einer Beschichtungsbildung auf einer Fläche des kornorientierten Elektrostahlblechs (S) ausgelegt ist, das unter einer Bedingung mit reduziertem Druck durch einen Beschichtungsbildungsbereich (43) in der Beschichtungsbildungskammer (42) geführt wird;
eine an einer Eingangsseite der Beschichtungsbildungskammer (42) angeordnete Eingangsdekompressionsanlage (21) mit mehrstufigen Eingangsdekompressionskammern (22), durch die das kornorientierte Elektrostahlblech (S), das der Beschichtungsbildung noch nicht unterworfen wurde, geführt wird, wobei sich der Innendruck in den mehrstufigen Eingangsdekompressionskammern (22) in Richtung der Beschichtungsbildungskammer (42) dem Innendruck in der Beschichtungsbildungskammer (42) annähert; und
eine an einer Ausgangsseite der Beschichtungsbildungskammer (42) angeordnete Ausgangsdekompressionsanlage (51) mit mehrstufigen Ausgangsdekompressionskammern (52), durch die das kornorientierte Elektrostahlblech (S), das der Beschichtungsbildung unterworfen wurde, geführt wird, wobei sich der Innendruck in den mehrstufigen Ausgangsdekompressionskammern (52) mit zunehmendem Abstand von der Beschichtungsbildungskammer (42) Luftdruck annähert,
wobei die mehrstufigen Eingangsdekompressionskammern (22) und die mehrstufigen Ausgangsdekompressionskammern (52) Folgendes beinhalten:
eine Trennplatte (54), die jede Dekompressionskammer definiert und mit einer Blechdurchführungsöffnung (55) bereitgestellt ist,
die derart geformt ist, dass sie ein ungehindertes Durchführen des kornorientierten Elektrostahlblechs (S) dadurch ermöglicht; und
Dichtungspolster (81), die anstelle von Andruckwalzen an einer Ober- und Unterseite der Blechdurchführungsöffnung (55) in der Trennplatte (54) angeordnet sind,
**dadurch gekennzeichnet, dass** ein Spalt (G) zwischen den Dichtungspolstern (81) 1,0 bis 2,0 mm beträgt und
dass die Dichtungspolster (81) aus Harz hergestellt sind.

2. Anlage (1) zum Produzieren von kornorientierten Elektrostahlblechen nach Anspruch 1,
wobei die Beschichtungsbildungsanlage (41) die Beschichtungsbildung durch ein Verfahren zur chemischen Gasphasenabscheidung oder ein Verfahren zur physikalischen Gasphasenabscheidung durchführt.

3. Anlage (1) zum Produzieren von kornorientierten Elektrostahlblechen nach Anspruch 1 oder 2, ferner umfassend:
Kühlwalzen (45), die auf einer stromabwärts gelegenen Seite des Beschichtungsbildungsbereichs (43) in einer Förderrichtung in der Beschichtungsbildungskammer (42) angeordnet sind und durch die das kornorientierte Elektrostahlblech (S), das der Beschichtungsbildung unterworfen wurde, geführt wird.

4. Anlage (1) zum Produzieren von kornorientierten Elektrostahlblechen nach Anspruch 3,
wobei es sich bei den Kühlwalzen (45) um Spannwalzen handelt.

5. Anlage (1) zum Produzieren von kornorientierten Elektrostahlblechen nach einem der Ansprüche 1 bis 4, ferner umfassend:
eine Polieranlage (13), die auf der stromaufwärts gelegenen Seite der Beschichtungsbildungskammer (42) in einer Förderrichtung angeordnet und zum Polieren der Fläche des geförderten kornorientierten Elektrostahlblechs (S) ausgelegt ist.

6. Anlage (1) zum Produzieren von kornorientierten Elektrostahlblechen nach einem der Ansprüche 1 bis 5, ferner umfassend:
eine Vorbehandlungsanlage (31) mit einer Vorbehandlungskammer (32) zwischen den mehrstufigen Eingangsdekompressionskammern (22) und der Beschichtungsbildungskammer (42), wobei die Vorbehandlungsanlage (31) zum Durchführen einer Vorbehandlung ausgelegt ist, bei der Verunreinigungen von der Fläche des kornorientierten Elektrostahlblechs (S), das der Beschichtungsbildung noch nicht unterworfen wurde und in die Vorbehandlungskammer (32) eingeführt ist, entfernt werden, wobei es sich bei einem Verfahren der Vorbehandlung um Ionenzerstäuben handelt.

7. Anlage (1) zum Produzieren von kornorientierten Elektrostahlblechen nach Anspruch 6,
wobei eine Trennwand (39) zum Trennen der Vorbehandlungskammer (32) und der Beschichtungsbildungskammer (42) bereitgestellt ist,
wobei die Trennwand (39) mit einer Trennwand-Blechdurchführungsöffnung (40) bereitgestellt ist, die derart geformt ist, dass sie ein ungehindertes Durchführen des kornorientierten Elektrostahlblechs (S) dadurch ermöglicht, und
wobei die Dichtungspolster (81) auf einer Ober- und Unterseite der Trennwand-Blechdurchführungsöffnung (40) in der Trennwand angeordnet sind.

## Revendications

1. Installation (1) destinée à fabriquer des tôles d'acier électriques à grains orientés, comprenant :
un mécanisme de transport (19, 20) configuré pour transporter une tôle d'acier électrique à grains orientés (S) ayant subi un recuit final ;
une installation de formation de revêtement (41) présentant une chambre de formation de revêtement (42) à travers laquelle passe la tôle d'acier électrique à grains orientés (S) transportée, l'installation de formation de revêtement (41) étant configurée pour effectuer la formation de revêtement sur une surface de la tôle d'acier électrique à grains orientés (S) qui passe à travers une zone de formation de revêtement (43) dans la chambre de formation de revêtement (42) dans des conditions de pression réduite ;
une installation de décompression d'entrée (21) disposée sur un côté entrée de la chambre de formation de revêtement (42) et présentant des chambres de décompression d'entrée à plusieurs étages (22) à travers lesquelles passe la tôle d'acier électrique à grains orientés (S) n'ayant pas encore subi la formation de revêtement, une pression interne dans les chambres de décompression d'entrée à plusieurs étages (22) étant proche d'une pression interne dans la chambre de formation de revêtement (42) vers la chambre de formation de revêtement (42) ; et
une installation de décompression de sortie (51) disposée sur un côté sortie de la chambre de formation de revêtement (42) et présentant des chambres de décompression de sortie à plusieurs étages (52) à travers lesquelles passe la tôle d'acier électrique à grains orientés (S) ayant subi la formation de revêtement, une pression interne dans les chambres de décompression de sortie à plusieurs étages (52) étant proche d'une pression atmosphérique à distance de la chambre de formation de revêtement (42),
dans laquelle les chambres de décompression d'entrée à plusieurs étages (22) et les chambres de décompression de sortie à plusieurs étages (52) comportent :
une plaque de séparation (54) délimitant chaque chambre de décompression et pourvue d'un trou de passage de tôle (55) formé pour permettre à la tôle d'acier électrique à grains orientés (S) de passer librement à travers celui-ci ; et
des tampons d'étanchéité (81) disposés à la place de rouleaux pinceurs sur des côtés supérieur et inférieur du trou de passage de tôle (55) dans la plaque de séparation (54),
**caractérisée en ce qu'**un espace (G) entre les tampons d'étanchéité (81) est de 1,0 à 2,0 mm, et
**en ce que** les tampons d'étanchéité (81) sont fabriqués en résine.

2. Installation (1) destinée à fabriquer des tôles d'acier électriques à grains orientés (S) selon la revendication 1, dans laquelle l'installation de formation de revêtement (41) effectue la formation de revêtement par un procédé de dépôt chimique en phase vapeur ou un procédé de dépôt physique en phase vapeur.

3. Installation (1) destinée à fabriquer des tôles d'acier électriques à grains orientés (S) selon la revendication 1 ou 2, comprenant en outre :
des rouleaux refroidisseurs (45) qui sont disposés sur un côté aval de la zone de formation de revêtement (43) dans une direction de transport dans la chambre de formation de revêtement (42) et à travers lesquels passe la tôle d'acier électrique à grains orientés (S) ayant subi la formation de revêtement.

4. Installation (1) destinée à fabriquer des tôles d'acier électriques à grains orientés (S) selon la revendication 3, dans laquelle les rouleaux refroidisseurs (45) sont des rouleaux à bride.

5. Installation (1) destinée à fabriquer des tôles d'acier électriques à grains orientés (S) selon l'une quelconque des revendications 1 à 4, comprenant en outre :
une installation de polissage (13) disposée sur un côté amont de la chambre de formation de revêtement (42) dans une direction de transport et configurée pour polir la surface de la tôle d'acier électrique à grains orientés (S) transportée.

6. Installation (1) destinée à fabriquer des tôles d'acier électriques à grains orientés (S) selon l'une quelconque des revendications 1 à 5, comprenant en outre :
une installation de prétraitement (31) présentant une chambre de prétraitement (32) entre les chambres de décompression d'entrée à plusieurs étages (22) et la chambre de formation de revêtement (42), l'installation de prétraitement (31) étant configurée pour effectuer un prétraitement au cours duquel des impuretés sont éliminées de la surface de la tôle d'acier électrique à grains orientés (S) n'ayant pas encore subi la formation de revêtement et introduite dans la chambre de prétraitement (32), dans laquelle un procédé du prétraitement est la pulvérisation ionique.

7. Installation (1) destinée à fabriquer des tôles d'acier électriques à grains orientés (S) selon la revendication 6, dans laquelle une paroi de séparation (39) est prévue pour séparer la chambre de prétraitement (32) et la chambre de formation de revêtement (42),
dans laquelle la paroi de séparation (39) est pourvue d'un trou de passage de tôle de paroi de séparation (40) formé pour permettre à la tôle d'acier électrique à grains orientés (S) de passer librement à travers celui-ci, et
dans laquelle les tampons d'étanchéité (81) sont disposés sur des côtés supérieur et inférieur du trou de passage de tôle de paroi de séparation (40) dans la paroi de séparation.
